# EUROPEAN PATENT SPECIFICATION

(11) **EP 0 407 807 B1**
(45) Date of publication and mention of the grant of the patent: **08.01.1997**
(21) Application number: 90112144.2
(22) Date of filing: 26.06.1990
(51) Int. Cl.: H01L 51/30, H01L 39/12

(54) **Electroconductive organic thin film and process for producing the same**
Elektrisch leitender organischer Dünnfilm und Verfahren zur Herstellung desselben
Couche mince organique électroconductive et procédé de fabrication de celui-ci

(30) Priority: 26.06.1989 JP 160632/89; 23.08.1989 JP 214951/89; 11.12.1989 JP 320976/89; 31.03.1990 JP 87228/90
(43) Date of publication of application: 16.01.1991
(73) Proprietor: SUMITOMO ELECTRIC INDUSTRIES, LTD., Osaka-shi, Osaka 541 (JP)
(72) Inventor: Ueba, Yoshinobu Osaka Works of Sumitomo Electric, Osaka-shi, Osaka (JP); Mishima, Takayuki Osaka Works of Sumitomo Electric, Osaka-shi, Osaka (JP); Kusuhara, Hiroyuki, Takatsuki-shi, Osaka (JP)
(74) Representative: Grünecker, Kinkeldey, Stockmair & Schwanhäusser Anwaltssozietät

(56) References cited:
- US-A- 4 632 776
- PATENT ABSTRACTS OF JAPAN, vol. 14, no. 338 (E-954) 20 July 1990; & JP-A-02 114 574
- PHYSICA C, vol. 156, no. 1, 1 August 1988, Amsterdam NL, pp. 173-176; H.H. WANG et al.: "ESR STUDIES OF THE 10.4 K AMBIENT-PRESSURE ORGANIC SUPERCONDUCTOR k-(BEDT-TTF)2Cu(NCS)2"
- JOURNAL OF MOLECULAR ELECTRONICS, Jan./March 1989, vol. 5, no. 1, Chichester GB, pp. 25-32; E.B. YAGUBSKII et al.: "Organic Conductors and Superconductors Based on Bis(ethylenedithio)tetrathiafulvalene and its Derivatives"
- PATENT ABSTRACTS OF JAPAN, vol. 12, no. 188 (P-711) 2 June 1988; & JP-A-62 295 031
- PATENT ABSTRACTS OF JAPAN, vol. 10, no. 248 (E-431) 26 August 1986; & JP-A-61 077 322

## Description

The present invention relates to an organic film having semiconductivity, electroconductivity or even superconductivity. More particularly, the present invention relates to an electroconductive organic thin film made of a vapor-deposited bis(ethylenedithiotetrathiafulvalene (BEDT-TTF) film having an electron acceptor incorporated therein, as well as process for producing such an organic thin film.

Further, the present invention relates to a vapor-deposited BEDT-TTF film that can be used as an electroconductive organic thin film, as well as a process for producing such vapor-deposited film.

Organic thin films can be produced by various techniques such as a Langmuir-Blodgett (LB) method, vapor deposition, an ionized cluster beam (ICB) method and a molecular beam epitaxy (MBE) method. Using these methods, semiconductive or electroconductive organic thin films have been prepared from tetracyanoquinodimethane (TCNQ), tetrathiofulvalenetetracyanoquinodimethane (TTF-TCNQ), metal-phthalocyanine, etc., and insulator films form aliphatic acids, etc.

Because of their nature as electric conductors, or semiconductors, organic thin films having electroconductivity have potential use in electronics, opto-electronics, energy conversion and other fields of application. In particular, organic thin films having high conductivity hold promise for use in many applications including micro-wiring, striplines, sensors, display devices, memories and switching devices. However, no organic thin films that have high electroconductivity like metals are yet to be realized.

It has recently been proposed that an organic semiconductor or conductor film be prepared by a process that includes the steps of forming a film of an electron-donating organic compound such as a ful valene containing a chalcogen atom in the molecule on an electrode substrate, and oxidizing said film by electrolysis (Unexamined Published Japanese Patent Application No. 289013/1989). According to a specific example disclosed in this prior patent, BEDT-TTF as an electron-donating organic compound was vacuum-deposited on a platinum-evaporated glass substrate, and gold was vacuum-deposited on the resulting BEDT-TTF film to form an electrode, and subsequently, the electrode was electrolytically oxidized with tetraethyl ammonium perchlorate used as an electrolyte, whereby a film having conductivity of 3 x 10⁻³ S/cm was obtained.

However, this organic thin film and all others that are produced by the conventional methods have conductivity lower than that of metals and no organic thin film has been known to have high conductivity comparable to metals. Further, the temperature dependency of the conductivity of prior art conductive organic thin films does not show a metallic behavior and no organic thin film has been known that exhibits superconductivity.

Another problem with the prior art is that the melting point and the decomposition point of BEDF-TTF are so close to each other that it is extremely difficult to vaporize BEDF-TTF without generating decomposition products. If it were possible to prepare a vapor-deposited BEDT-TTF containing no decomposition products, an organic thin film having high conductivity could be produced by incorporating an electron acceptor into said BEDT-TTF film. However, no method has so far been proposed that is directed to forming a vapor-deposited BEDT-TTF film having such high quality and purity.

Accordingly, there has been no report published on the possibility of using the vapor-deposited BEDT-TTF film to make an organic thin film that shows high conductivity or even superconductivity.

It is, therefore, an object of the present invention to provide an organic thin film having semiconductivity or electroconductivity, in particular, an organic thin film that shows high or metal-like conductivity or even superconductivity.

Another object of the present invention is to provide a process for producing a vapor-deposited BEDT-TTF film of high purity in which the generation of decomposition products is prevented or minimized.

According to the present invention, the first object is attained by an electroconductive thin bis(ethylenedithio)tetrathiafulvalene (BEDT-TTF) film containing an electron acceptor on a substrate.

Further, the present invention provides a process for producing a vapor-deposited BEDT-TTF film, which process comprises the steps of:
heating BEDT-TTF to a predetermined temperature of up to 260° under vacuum; and forming a BEDT-TTF film on a substrate held at a temperature less than the temperature to which said BEDT-TTF is heated.

It has hitherto been held that the melting point and the decomposition temperature of BEDT-TTF are so close to each other that upon heating, it hardly vaporizes but will simply decompose. However, to one's surprise, if BEDT-TTF is vapor-deposited in vacuo at a temperature not higher than 260°C which is the decomposition point as determined from thermogravimetric (TG)-differential thermal analysis (DTA), preferably at a low temperature of 250°C or below, a satisfactory thin film of BEDT-TTF can be formed on a substrate without letting the BEDF-TTF decompose. Further, a vapor-deposited BEDT-TTF film of high purity that does not contain any decomposition product can be efficiently formed on a substrate in a tubular vapor-depositing vessel with a temperature gradient being created along the tube wall.

While various conductive substrates can be employed, the present inventors found that a dense BEDT-TTF film having a high degree of orientation and having the major axes of the fine crystals of BEDT-TTF oriented perpendicular to the substrate surface could be obtained by using a silicon substrate.

Further, by combining this film forming step with the step of incorporating an electron acceptor, an organic thin film having semiconductivity or electroconductivity or even superconductivity can be obtained, if the respective method, the concentration and the type of the electron acceptor are properly selected.

The present invention has been accomplished on the basis of these findings and is disclosed in independent claims 1 and 4.

Other objects, features and characteristics of the present invention, as well as the methods of operation and function of the related elements of the structure, and the combination of parts and economies of manufacture, will become more apparent upon consideration of the following detailed description and the appended claims with reference to the accompanying drawings all of which form a part of this specification.

In the following a brief description of the drawings is given.
FIG. 1 is TG-DTA spectra of BEDT-TTF;
FIG. 2 is a schematic cross-sectional view of an apparatus that is used to form a vapor-deposited BEDT-TTF film on substrates;
FIG. 3 is a diagram showing the temperature profile along the wall of the quartz tube in the vapor-deposited film forming apparatus shown in FIG. 2;
FIG. 4 is a scanning electron microscopic (SEM) picture of a cross section of the vapor-deposited BEDT-TTF film formed on an n-type silicon (100) substrate in Example 2, and it shows the crystalline structure of that film (see the central white layer), with the substrate shown as the lower layer and the white line on the right side representing a scale equivalent to 10 µm in length;
FIG. 5 is a SEM picture of a cross section of the vapor-deposited BEDT-TTF film formed on an indium oxide coated glass substrate in Example 3, and it shows the crystalline structure of that film (see the central white layer), with the substrate shown as the lower layer and the white line on the right side representing a scale equivalent to 10 µm in length;
FIG. 6 is a cross section of an electroconductive substrate having a vapor-deposited BEDT-TTF film formed thereon;
FIG. 7 is a schematic diagram of a reactor for preparing an electrolytic solution containing an electron acceptor;
FIG. 8 is a schematic diagram of an apparatus for performing the incorporation of an electron acceptor by an electrolytic method;
FIG. 9 is the FTIR spectra of a starting BEDT-TTF powder and a vapor-deposited BEDT-TTF film;
FIG. 10 is an X-ray diffraction of a BEDT-TTF film;
FIG. 11 is an X-ray diffraction of a starting BEDT-TTF powder;
FIG. 12 is an X-ray diffraction of the X-(BEDT-TTF)₂Cu(NCS)₂ film obtained in Example 4; and
FIG. 13 is an X-ray diffraction of the X-(BEDT-TTF)₂Cu(NCS)₂ film obtained in Examples.

In the following the preferred embodiments of the present invention are described in detail.

According to the general procedure of vacuum deposition, a sample in a vacuum enclosure held in high vacuum is heated to vaporize and its molecules are allowed to condense without involving any chemical reaction to form a vapor-deposited film on a substrate held at a predetermined temperature. Because of its operating principle, vacuum deposition is applied to materials that are solid at ordinary temperatures and pressures and that will not decompose upon heating.

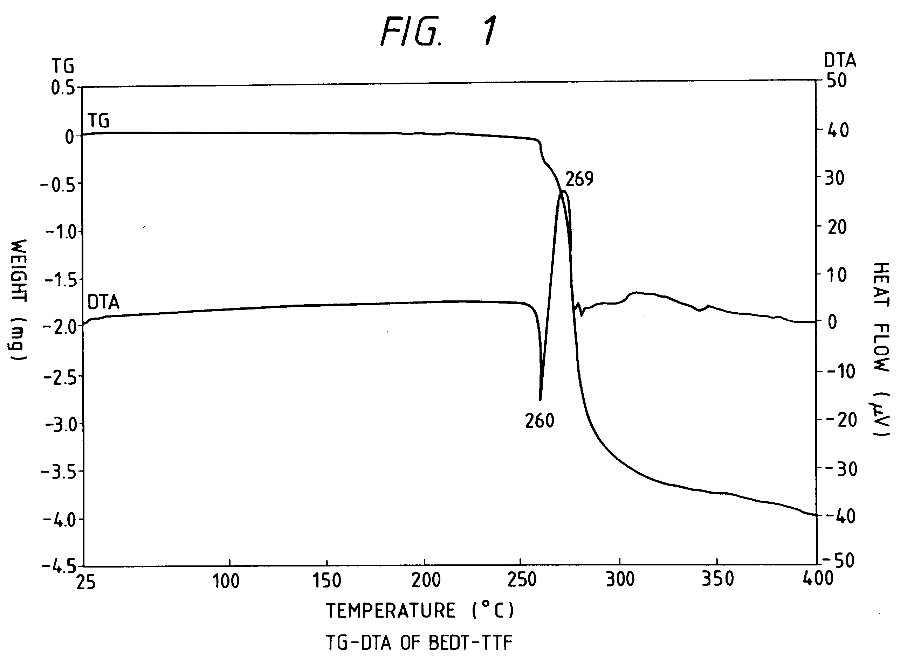

As is apparent from the results of thermogravimetric (TG)-differential thermal analysis (DTA) shown in FIG. 1, it has been held that BEDT-TTF has a melting point (Tm = 258°C) and a decomposition temperature (260°C) which are so close to each other that upon heating it hardly vaporizes but will simply decompose. As a matter of fact, if one attempts to form a vapor-deposited BEDT-TTF film on a substrate by the usual vacuum deposition technique, a volatile decomposition product will be generated and incorporated in the resulting vapor deposited film. Even if an electron acceptor is incorporated into such a film, no practical conductive film can be formed.

However, to one's surprise, if BEDT-TTF is heated under vacuum from room temperature to a predetermined temperature of up to 260°C and if a BEDT-TTF film is formed on a substrate held at a temperature lower than the temperature to which the BEDT-TTF is heated, a vapor-deposited BEDT-TTF film with a reduced content of the decomposition product can be obtained.

In accordance with the present invention, a thin BEDT-TTF film can be formed with an ordinary thermal deposition apparatus, preferably a tubular vessel, by a vacuum deposition method or MBE method in which the thin-film forming material is heated to vaporize in high vacuum and the vapor is condensed on a substrate to form a thin film.

Stated more specifically, BEDT-TTF is heated in vacuo at a pressure of 1.333 Pa (10⁻² Torr) or below, preferably at 0.133 to 1.333 x 10⁻⁸ Pa (10⁻³ to 10⁻¹⁰Torr), more preferably in high vacuum at a pressure of 1.333 x 10⁻³ to 1.333 x 10⁻⁸ Pa (10⁻⁵ to 10⁻¹⁰ Torr), and at a temperature of up to 260°C, preferably between 180 and 250°C, whereby a vapor-deposited BEDT-TTF film is formed on a substrate.

If the heating temperature exceeds 260°C, BEDT-TTF will decompose. The temperature at which the starting BEDT-TTF is heated can be made lower than 260°C by reducing the pressure in the system below 1,333·10⁻³ Pa (10⁻⁵ Torr). For instance, if vapor deposition is performed in a high-vacuum atmosphere at a pressure of about 1,333·10⁻⁸ Pa (10⁻¹⁰ Torr), the temperature at which the starting BEDT-TTF is heated can be lowered to about 180-200°C.

Further, a vapor-deposited BEDT-TTF film containing no decomposition products can be obtained efficiently by carrying out the above-described procedure in a tubular vapor-depositing vessel, with a temperature gradient being created along on the tube wall.

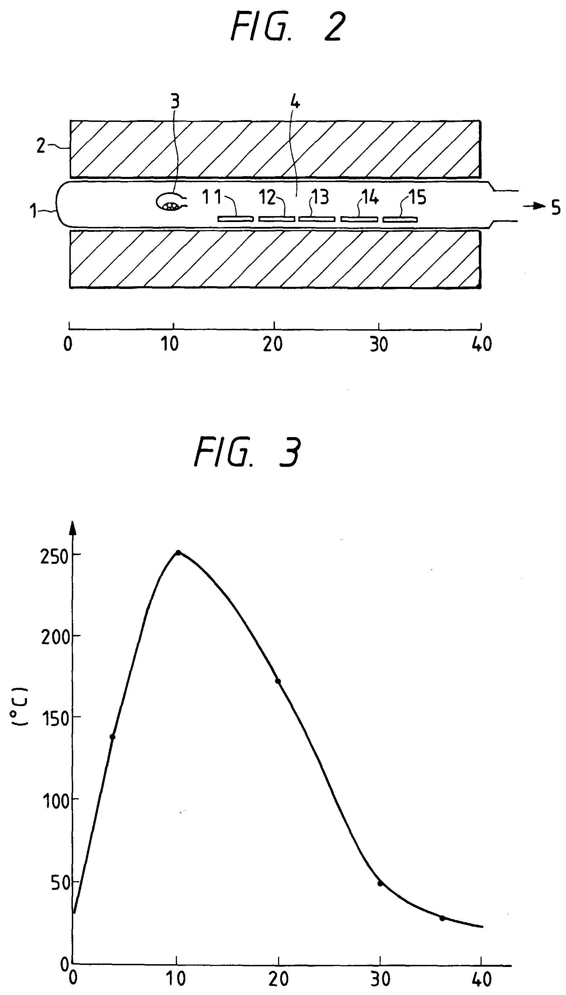

As shown specifically in FIG. 2, the fine crystals or powder of BEDT-TTF in a feed cell 3 is put into a tubular vapor-depositing vessel (vacuum enclosure) 1. Substrates 1-5 are placed in the vessel 1 along the length of the tube wall at given distances from the feed cell 3. The vessel 1 is set horizontally within a tubular furnace 2.

After evacuating the vessel, the feed cell is heated to a predetermined temperature less than 260°C and held at that temperature for a given period. The thickness of vapor-deposited film can be adjusted by controlling such factors as the distance between the feed cell and each substrate, the temperature to which the feed cell is heated, the time for which said temperature is maintained, and the degree of vacuum.

The distance between the feed cell and each substrate and the temperature at which the substrates are heated are two important factors for obtaining a vapor-deposited BEDT-TTF film of good quality that does not contain decomposition products. If the distance between the feed cell and each of the substrates increases to lower the substrate temperature, a yellow decomposition product is likely to be deposited on the substrates. A vapor-deposited BEDT-TTF film of good quality has a red to orange color and can be readily identified with the eye.

Therefore, a vapor-deposited BEDT-TTF film of good quality can be efficiently produced if the distance to each substrate and the substrate temperature that insure the formation of an orange-colored vapor-deposited film are determined by preliminary testing with the apparatus shown in FIG. 2 in connection with the temperature at which the feed ell is heated and the temperature gradient along the wall of the tubular vessel. FIG. 3 shows a typical temperature profile along the wall of the quartz tube in the vapor-deposited film forming apparatus shown in FIG. 2, and one can see from this graph that under the conditions of vapor deposition used in Example 1 to be described below, an orange-colored thin film of good quality that did not contain decomposition products could be formed on substrates 1-3 which were placed at distances in the range of 5-15 cm from the feed cell.

There is no particular limitation on the substrates that can be used in the present invention and illustrative example include substrates made of ITO glass, NESA glass, silicon, electroconductive polymer films or thin films, conductive LB films, carbon or graphite. Among these, silicon substrates (silicon wafers) made of (100) silicon (n- or p-type) and (111) silicon (n- or p-type) are preferred since, their use is effective in producing a vapor-deposited film characterized by a significant improvement in the orientation of the BEDT-TTF crystals.

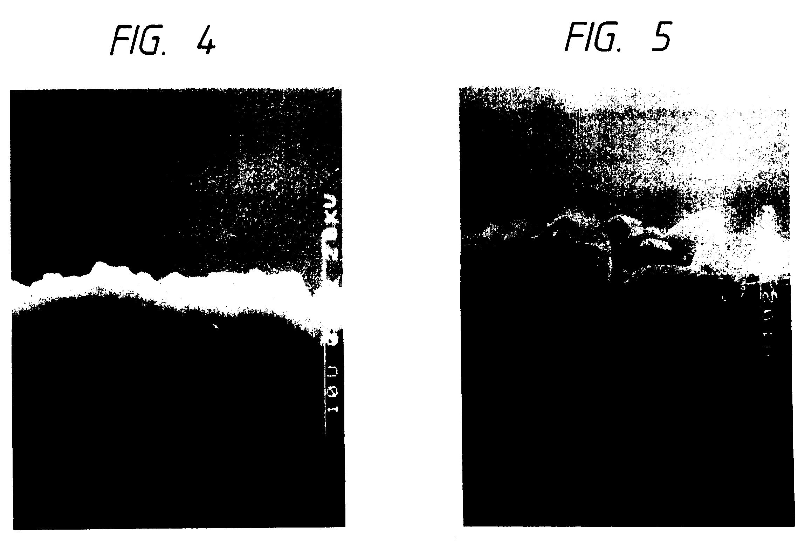

Vapor-deposited BEDT-TTF films are usually obtained as films in which the micro crystallites of BEDT-TTF are randomly oriented and agglomerated, and even if they are oxidized or doped electrolytically, the molecular orientation in the crystal still remains random and the failure to achieve high conductivity causes substantial difficulty in obtaining a superconductive film having small residual resistance. FIG. 5 is a scanning electron microscopic (SEM) picture of a cross section of a vapor-deposited BEDT-TTF film formed an indium oxide coated glass substrate, and it clearly shows the tendency of random orientation in the crystalline structure of the film.

It was found that the orientation of the BEDT-TTF crystallites was markedly improved when a silicon wafer was used as the substrate than when oxide conductor coated glass substrates such as ITO glass and NESA glass were used. It was also found that the vapor-deposited BEDT-TTF film prepared with a silicon wafer used as a substrate had the major axes of the micro crystallites of BEDT-TTF oriented perpendicular to the substrate surface. FIG. 4 is a SEM picture of a cross section of a vapor-deposited BEDT-TTF film formed on a silicon wafer substrate, and the film is obviously a dense film having the major axes of the fine crystals of BEDT-TTF oriented perpendicular to the substrate surface. The thus obtained vapor-deposited BEDT-TTF film having a high degree of orientation is morphologically preferred for incorporating an electron acceptor.

The vapor-deposited BEDT-TTF film produced by the process of the present invention is an insulator per se but an electroconductive or even superconducting organic thin film can be obtained if an electron acceptor is incorporated into this BEDT-TTF film by a suitable method such as a vapor-phase method, a liquid-phase method, an electrochemical method or an ion-implantation method.

The process for producing an electroconductive organic thin film in accordance with the present invention comprises the following two basic steps:
(1) heating BEDT-TTF in vacuo at a pressure of 1.333 Pa (10⁻² Torr) or below at a temperature not higher than 260°C so as to form a vapor-deposited BEDT-TTF film on a substrate; and
(2) incorporating an electron acceptor into the vapor-deposited BEDT-TTF film.
Steps (1) and (2) are usually performed consecutively but if the incorporation method adopted permits, an electron aceptor may be incorporated as the vapor-deposited film is formed.

Examples of the electron acceptor that may be used in the present invention include: trihalide anions such as I₃⁻, Br₃⁻ , IBr₂⁻, ICl₂⁻ and I₂Br⁻ that are represented by X₃⁻ (X is a halogen atom); anions that are represented by MX₂⁻ (M is a metal atom; and X is a halogen atom or a pseudo halide such as AuI₂⁻, AuIBᵣ⁻, AuBr₂⁻, Cu(NCS)₂⁻, Ag(NCS)₂⁻, Au(NCS)₂⁻, Cu⁻(NCSe)₂⁻, Cu(NCO)₂⁻ and Au(CN)₂; and other anions such as NO₃⁻, BF₄⁻, ClO₄⁻, ReO₄⁻ and PF₄⁻. Among these anions, X₃⁻ and MX₂⁻ are particularly preferred for the purpose of obtaining an organic superconducting thin film.

By incorporating these electron acceptors into the vapor-deposited BEDT-TTF an organic thin film that shows conductivity or superconductivity can be obtained.

While electron acceptors can be incorporated by various methods including an electrochemical method and a vapor-phase method, the use of an electrochemical method is preferred. Incorporation by an electrochemical method can be performed in the usual manner with a known electrochemical crystallizing apparatus.

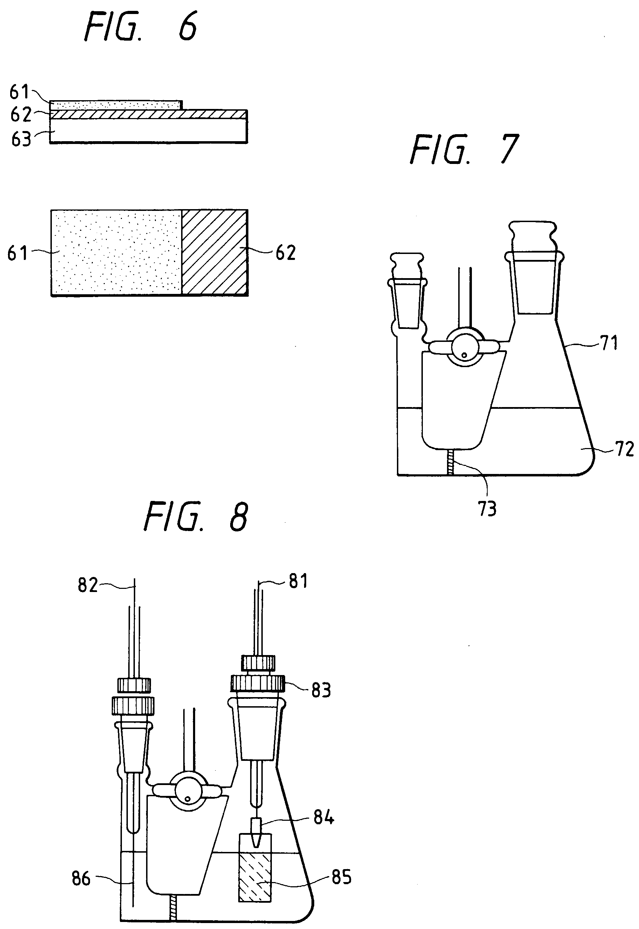

FIG. 6 shows a vapor-deposited BEDT-TTF film 61 that is produced on a substrate made of an indium oxide layer 62 coated on glass 63. Into this vapor-deposited BEDT-TTF film an electron acceptor can advantageously be incorporated by an electrochemical method using a reactor 71 (see FIG.7) for preparing an electron acceptor containing electrolytic solution 72 and a reactor (see FIG. 8) for performing the incorporation of an electron acceptor. In the reactor shown in FIG. 8, an electroconductive substrate 85 having a vapor-deposited thin BEDT-TTF film is retained on the anode side and a platinum plate 86 is used as cathode, with the liquid electrolyte being a supporting electrolyte that contains one or more of the anions listed above and which is dissolved in an organic solvent solution that has strong polarity and that is resistant to oxidation and reduction. Electroconductivity can be adjusted by properly seiecting the type of anion and the degree of incorporation.

No report has heretofore been published on the preparation of vapor-deposited BEDT-TTF films of high quality that are free from the generation of decomposition products. This is because it has been held that BEDT-TTF has a melting point and a decomposition temperature that are so close to each other that it cannot be vaporized without decomposition. However, a satisfactory thin BEDT-TTF film can be formed on a substrate by heating BEDT-TTF in vacuo at a temperature of up to 260°C. In this case, a vapor-deposited BEDT-TTF film having a high degree of orientation can be obtained by using a silicon substrate.

Further, by properly selecting process parameters such as the type of electron acceptor to be incorporated into the BEDT-TTF film, the electroconductivity of the thin film to be obtained can be adjusted in such a way as to produce a conductive organic thin film that shows metal like properties.

### Examples

The following examples are provided for the purpose of further illustrating the present invention but are in no way to be taken as limiting.

### Example 1

Five glass plates (10 x 20 x 1 mm) coated with indium oxide (In₂O₃) were used as substrates for depositing a thin BEDT-TTF film on each of these substrates by the following procedure.

As shown in FIG. 2, a feed cell 3 charged with 50 mg of a BEDT-TTF powder and the five In₂O₃ coated glass substrates 1-5 were placed in a quartz reaction tube 1, which in turn was set in a two-zone tubular furnace 2. The quartz tube was evacuated with a vacuum pump capable of attaining an ultimate pressure of 1,333·10⁻³ Pa (10⁻⁵ Torr). The feed cell was heated from room temperature to 250°C and held at 250°C for 30 min. The resulting temperature profile in the area of the reaction tube where the substrates were placed was as shown in FIG. 3.

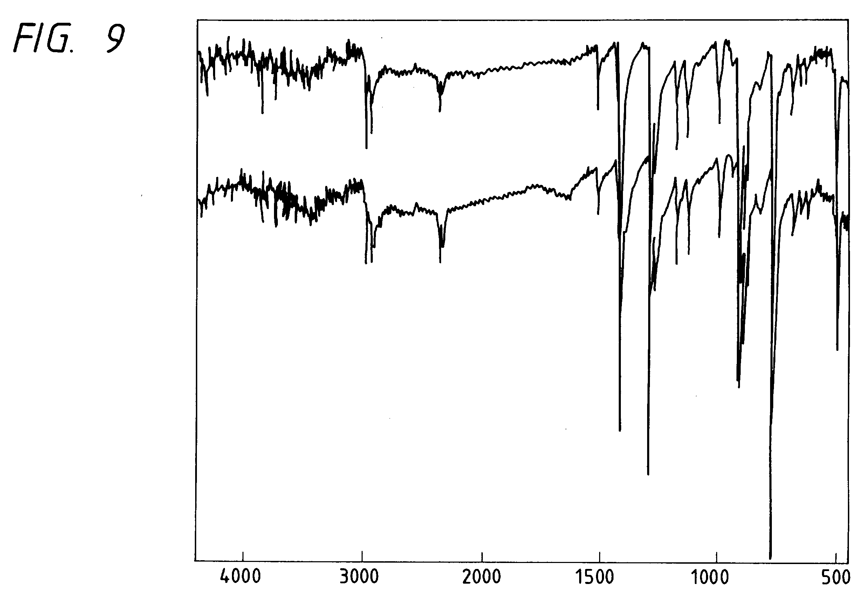

After cooling the tubular furnace 2 to room temperature, the quartz tube was taken out of the furnace and checked for the color and morphology of the vapor-deposited film on each of the substrates. An orange-colored thin film of good quality that did not contain decomposition products was obtained on substrates 1-3 that were placed at distances in the range of 5-15 cm from the feed cell, whereas a yellow thin film containing decomposition products was obtained on substrates 4 and 5 that were placed at distances in the range of >15 to 20 cm from the feed cell. Since the FTIR spectrum of each orange-colored vapor-deposited film was in agreement with that of the starting BEDT-TTF powder as shown in FIG. 9, this film as identified as being composed of BEDT-TTF.

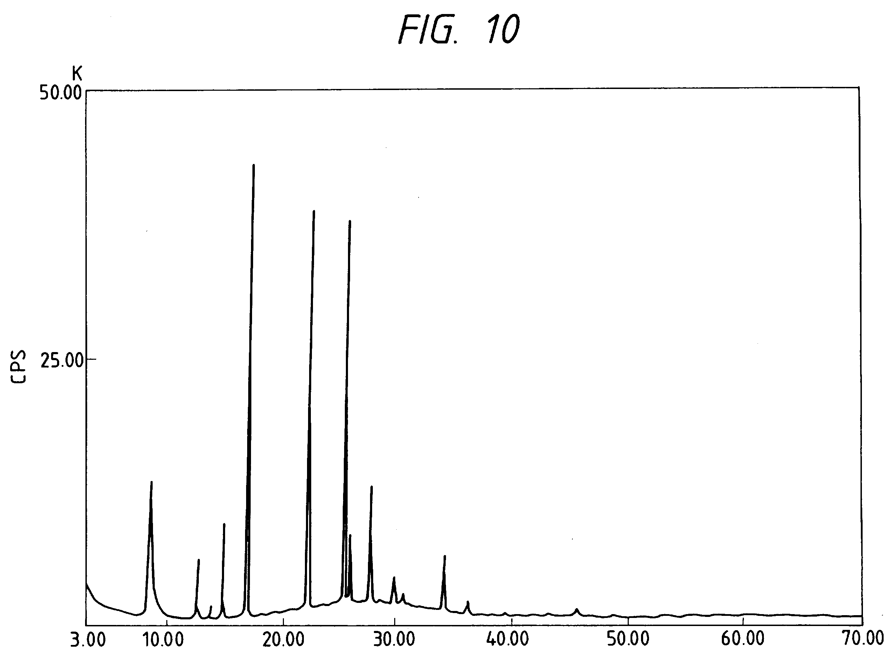

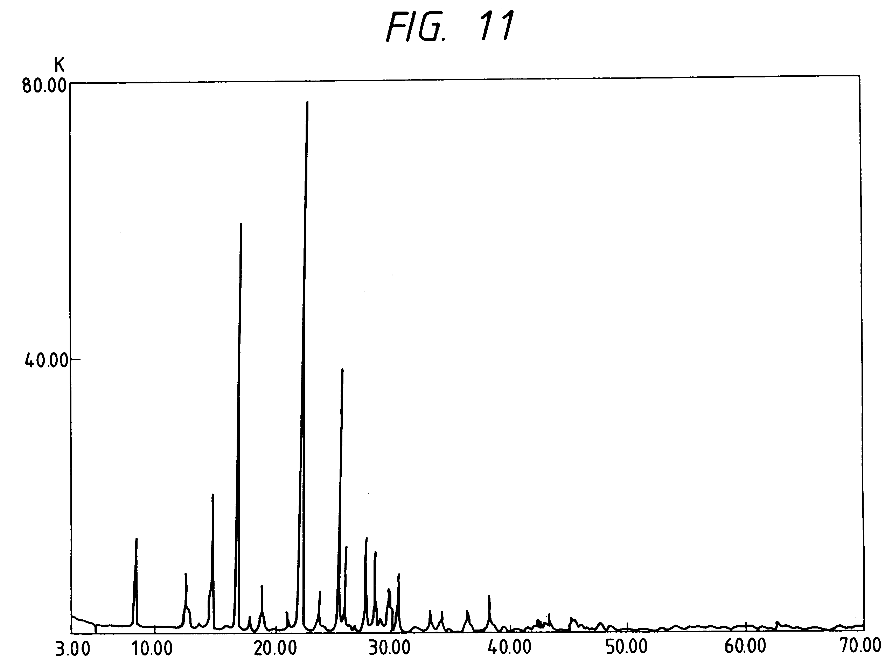

Comparison between an X-ray diffraction of the orange-colored vapor-deposited film (FIG. 10) and that of the starting BEDT-TTF powder (FIG. 11) shows that the vapor-deposited film had an improved degree of orientation. Observations with an optical microscope and a scanning electron microscope (SEM) showed that the orange-colored vapor-deposited film was composed of agglomerated micro crystallites of BEDT-TTF and that it had good quality in the absence of pinholes.

Similar experiments were conducted to prepare vapor deposited BEDT-TTF films using NESA glass or an ITO-coated polyester film as a substrate in place of the indium oxide coated glass substrate. Again, an orange-colored vapor-deposited BEDT-TTF film of good quality was obtained on each of the substrates placed at positions 1, 2 and 3 in Fig. 2.

### Example 2

A feed cell charged with 30 mg of BEDT-TTF and a substrate in the form of n-type silicon (100) wafer (resistance, 0.01-0.02 Ω·cm) that measured 1 x 3 cm were placed in a quartz reaction tube in such a way that the distance between the feed cell and the substrate was 10 cm. The reaction tube was then set in a two-zone tubular furnace.

The quartz tube was degassed and evacuated to a pressure of 0,133 Pa (10⁻³ Torr) and thereafter, the feed cell was heated up to 250°C at a rate of ca. 2-3°C/min and held at 250°C for 30 min. The temperature of the substrate was 175°C. After cooling the tubular furnace to room temperature by standing, the substrate was taken out of the furnace and found to have a light brown vapor-deposited film thereon. Similar results were obtained when a p-type silicon (100) wafer, a p-type silicon (111) wafer and an n-type silicon (111) wafer were used as substrates.

The FTIR spectrum of these thin films were in agreement with that of the starting BEDT-TTF powder, verifying the formation of the desired vapor-deposited film of BEDT-TTF without its decomposition. Observation with an optical microscope and a scanning electron microscope (SEM) showed that each of the vapor-deposited films was composed of agglomerated micro crystallites of BEDT-TTF and that they had satisfactory quality in the absence of pinholes.

FIG. 4 is a SEM picture of a cross section of one of the vapor-deposited BEDT-TTF films obtained in Example 2. The lower layer (black portion) in Fig. 4 is a part of the substrate and the central layer (white portion) is part of the vapor-deposited BEDT-TTF film. The white line on the right side of FIG. 4 represents a scale and its length corresponds to 10 µm. One can see from this SEM picture that the vapor-deposited film was a dense film having the major axes of the fine crystals of BEDT-TTF oriented perpendicular to the substrate surface. The thickness of this film as 4-5 µm.

### Example 3

A vapor-deposited BEDT-TTF film was prepared as in Example 2 except that the substrate was an indium oxide coated glass plate (10 x 20 x 1 mm). FIG. 5 is a SEM picture of a cross section of the vapor-deposited BEDT-TTF film obtained in Example 3. The lower layer (black portion) in FIG. 5 is part of the substrate and the central layer (white portion) is part of the vapor-deposited BEDT-TTF film. As is clear from FIG. 5, compared to the thin films obtained in Example 2 using a silicon wafer as the substrate, the vapor-deposited BEDT-TTF film obtained in Example 3 using the indium oxide coated glass substrate was rather random in orientation and somewhat less dense in structure. The film thickness was found to be within the range of 5-7 µm.

### Example 4

As in Example 1, an In₂O₃ coated glass substrate was placed in a quartz reaction tube in such a way that the distance between the feed cell and the substrate was 10 cm. The reaction tube was then set in a two-zone tubular furnace.

After evacuating the reaction tube to 1,333·10⁻³ Pa (10⁻⁵ Torr), the feed cell was heated to 250°C nd held at that temperature for 30 min. The substrate temperature was 175°C. As a result, an orange-colored thin film could be forced on the substrate. The thickness of this film was 2-3 µm.

Using a reactor shown by 71 in FIG. 7, 70 mg of CuSCN, 125 mg of KSCN and 210 mg of 18-crown-6 were dissolved in 100 ml of ethanol in a nitrogen gas atmosphere to thereby prepare a liquid electrolyte 72. As shown in FIG. 8, the substrate 85 having the vapor-deposited BEDT-TTF film was retained with a metal clip 84 on the anode side and a dc constant current of 10 µA was allowed to flow between the two electrodes 81 and 82 in a thermostatic chamber (not shown) held at 20°C. About 10 h later, the vapor-deposited film began to turn from orange to black, indicating the occurrence of a charge transfer reaction. After 24 hour reaction, the substrate was recovered, washed with ethanol and dried.

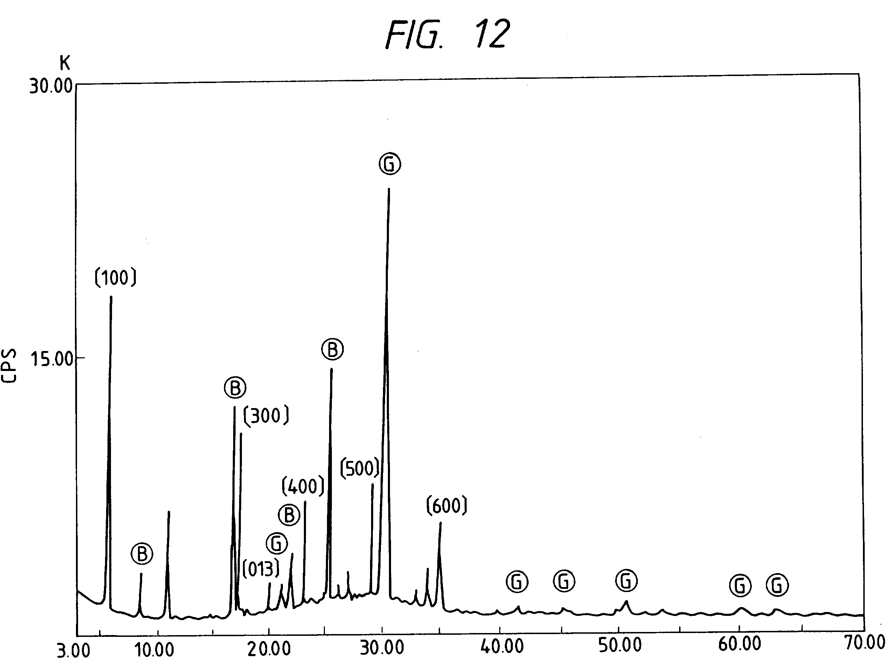

An X-ray diffraction of the resulting black thin film is shown in FIG. 12, from which two kinds of peaks are identified, one assignable to κ-(BEDT-TTF)₂Cu(NCS)₂ and the other assignable to unreacted BEDT-TTF.

When the dc magnetization of the black thin film was measured, the Meissner effect was evident at 8 K and this also verifies that the film was made of κ-(BEDT-TTF)₂Cu(NCS)₂. The black thin film had a conductivity of 0.1 S/cm at room temperature.

### Example 5

An electron acceptor was incorporated into the highly oriented, vapor-deposited BEDT-TTF film that was prepared in Example 2 using an n-type silicon (100) wafer as a substrate by an electrolyte method.

As in Example 4, 70 mg of CuSCN, 126 mg of KSCN and 210 mg of 18-crown-6 were dissolved in 100 ml of ethanol in a nitrogen gas atmosphere in a reactor shown by 71 in FIG. 7, whereby a liquid electrolyte 72 was prepared. Subsequently, as shown in FIG. 8, the silicon wafer substrate 85 having the vapor-deposited BEDT-TTF film was retained with a metal clip 84 on the anode side and a dc constant current of 10 µA was allowed to flow between the two electrodes 81 and 82 in a thermostatic chamber (not shown) held at 20°C. After 5-days of electrolytic treatment, the substrate with the film containing an electron acceptor was recovered, washed by dipping in ethanol and dried.

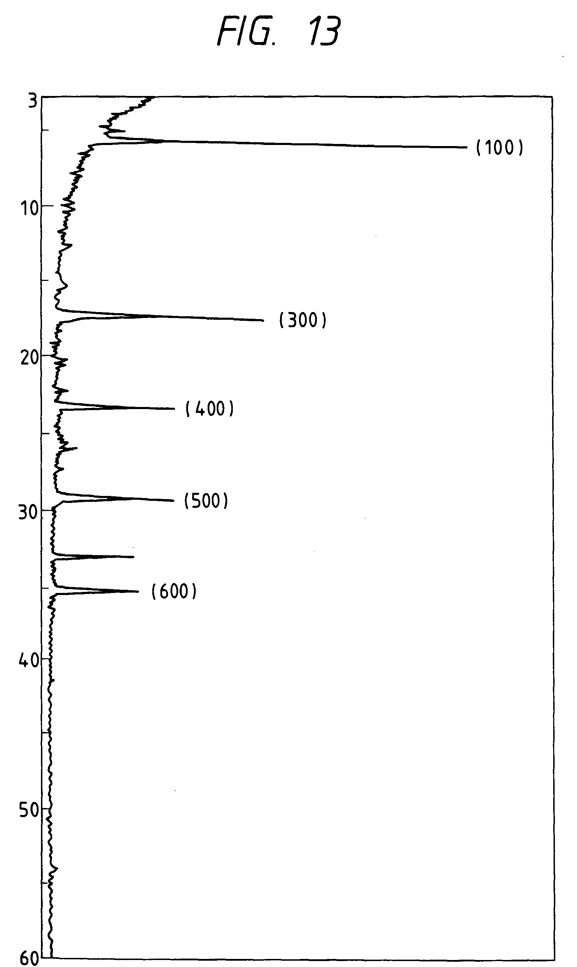

An X-ray diffraction of the dried film shown in Fig. 13 exhibits distinct (hOO) peaks that are only assignable to κ-(BEDT-TTF)₂Cu(NCS)₂.

When the dc magnetization of the resulting BEDT-TTF film containing Cu(NCS)₂⁻ was measured, the Meissner effect was evident at 9 K. This thin film had a. conductivity of 10 S/cm at room temperature.

### Example 6

An electron acceptor was incorporated into the vapor-deposited BEDT-TTF film that was prepared in Example 3 using an indium oxide coated glass substrate by an electrolytic method as in Example 5 so as to form a BEDT-TTF film containing [Cu(NCS)₂⁻] on the substrate.

When the dc magnetization of the resulting BEDT-TTF film containing Cu(NCS)₂⁻ was measured, the Meissner effect was evident at 7 K. This film had a lower superconducting transition temperature (Tc) than the conductive organic thin film prepared in Example 5, which may be ascribable to the relatively low orientation and density of the vapor-deposited film. The thin film obtained in Example 6 had a conductivity of 0.1 S/cm at room temperature.

### Example 7

A silicon wafer substrate having a BEDT-TTF film containing I₃⁻ was obtained by performing electrochemical treatment as in Example 5 except that 243 mg of tetrabutyl ammonium triiodide in 100 ml of ethanol was used as an electrolyte. When the dc magnetization of resulting BEDT-TTF film containing I₃⁻ measured after annealing at the temperature of liquid nitrogen, the Meissner effect was evident at 8 K. This film had a conductivity of 1 S/cm at room temperature.

### Example 8

As in Example 4, a vapor-deposited BEDT-TTF film was formed on an In₂O₃ coated glass substrate and subsequently iodine was incorporated into the film by an oxidation method. The resulting thin film had a conductivity of 10 S/cm at room temperature, which increased to 10³ S/cm at the temperature of liquid nitrogen.

### Example 9

A vapor-deposited BEDT-TTF film was formed on a substrate as in Example 4 except that the substrate was ITO glass. Subsequently, iodine was incorporated into the film by electrolytic oxidation. The resulting film had a conductivity of 200 S/cm at room temperature which increased to 10⁴ S/cm at the temperature of liquid nitrogen.

While the invention has been described in connection with what is presently considered to be the most practical and preferred embodiment, it is to be understood that the invention is not limited to the disclosed embodiment, but, on the contrary, is intended to cover various modifications and equivalent arrangements included within the scope of the appended claims.

## Claims

1. An electroconductive thin bis(ethylenedithio)tetrathiafulvalene (BEDT-TTF) film containing an electron acceptor on a substrate.

2. The electroconductive thin BEDT-TTF film according to claim 1, wherein the electron acceptor is at least one anion selected from X₃⁻ and MX₂⁻ (wherein X is a halogen atom or a pseudo halide; and M is a metal atom).

3. The electroconductive thin BEDT-TTF film according to claim 1, wherein said substrate is a silicon substrate.

4. A process for producing a vapor-deposited BEDT-TTF film, which process comprises the steps of:
heating BEDT-TTF to a predetermined temperature of up to 260° under vacuum; and forming a BEDT-TTF film on a substrate held at a temperature less than the temperature to which said BEDT-TTF is heated.

5. The process according to claim 4, further comprising the step of incorporating an electron acceptor into the BEDT-TTF film.

6. The process according to claim 4 or 5, wherein the BEDT-TTF film is formed on the substrate by heating the BEDT-TTF at a temperature of up to 250°C and at a pressure of 1,333 Pa (10⁻² Torr) or below.

7. The process according to any of claims 4 to 6, wherein the BEDT-TFF film is formed on the substrate in a tubular vapour depositing vessel with a temperature gradient created along the tube wall, and wherein the distance between the substrate and the feed cell of the vapor deposition apparatus is in the range of 5 to 15 cm.

8. The process according to any of claims 5 to 7, wherein the electron acceptor is incorporated into the BEDT-TFF film by an electrolytic method.

9. The process according to any of claims 5 to 8, wherein the electron acceptor is at least one anion selected from X₃⁻ and MX₂⁻ (wherein X is a halogen atom or a pseudo halide; and M is a metal atom).

10. The process according to any of claims 4 to 9, wherein the substrate is a silicon substrate.

## Patentansprüche

1. Elektrisch leitender Bis(ethylendithio)-tetrathiafulvalen (BEDT-TTF) -Dünnfilm, enthaltend einen Elektronenakzeptor auf einem Substrat.

2. Elektrisch leitender BEDT-TTF-Dünnfilm nach Anspruch 1, worin der Elektronenakzeptor mindestens ein Anion, gewählt aus X₃⁻ und MX₂⁻ ist (worin X ein Halogenatom oder ein Pseudohalogenid bedeutet; und M ein Metallatom bedeutet).

3. Elektrisch leitender BEDT-TTF-Dünnfilm nach Anspruch 1, worin das Substrat ein Siliciumsubstrat ist.

4. Verfahren zum Herstellen eines aufgedampften BEDT-TTF-Films, welches die Schritte umfaßt:
Erwärmen von BEDT-TTF auf eine vorbestimmte Temperatur von bis zu 260° unter Vakuum; und
Bilden eines BEDT-TTF-Films auf einem Substrat, das auf einer Temperatur gehalten wird, die geringer ist als die Temperatur, auf die das BEDT-TTF erwärmt wird.

5. Verfahren nach Anspruch 4, weiterhin umfassend den Schritt, daß ein Elektronenakzeptor in den BEDT-TTF-Film eingearbeitet wird.

6. Verfahren nach Anspruch 4 oder 5, worin der BEDT-TTF-Film auf dem Substrat durch Erwärmen des BEDT-TTF auf eine Temperatur von bis zu 250°C und bei einem Druck von 1,333 Pa (10⁻² Torr) oder niedriger gebildet wird.

7. Verfahren nach einem der Ansprüche 4 bis 6, worin der BEDT-TTF-Film auf dem Substrat in einem röhrenförmigen Aufdampfgefäß mit einem entlang der Röhrenwand erzeugten Temperaturgradienten gebildet wird, und worin die Entfernung zwischen dem Substrat und der Einspeisezelle der Aufdampfvorrichtung im Bereich von 5 bis 15 cm liegt.

8. Verfahren nach einem der Ansprüche 5 bis 7, worin der Elektronenakzeptor in den BEDT-TTF-Film durch ein elektrolytisches Verfahren eingearbeitet wird.

9. Verfahren nach einem der Ansprüche 5 bis 8, worin der Elektronenakzeptor mindestens ein Anion, gewählt aus X₃⁻ und MX₂⁻ ist (worin X ein Halogenatom oder ein Pseudohalogenid bedeutet; und M ein Metallatom bedeutet).

10. Verfahren nach einem der Ansprüche 4 bis 9, worin das Substrat ein Siliciumsubstrat ist.

## Revendications

1. Film mince électroconducteur bis(éthylènedithio)tétrathiafulvalène (BEDT-TTF) contenant un accepteur d'électrons sur un substrat.

2. Film mince électroconducteur BEDT-TTF selon la revendication 1, où l'accepteur d'électrons est au moins un anion sélectionné parmi X₃⁻ et MX₂⁻ (où X est un atome d'halogène ou un pseudohalogénure ; et M est un atome de métal).

3. Film mince électroconducteur BEDT-TTF selon la revendication 1, où ledit substrat est un substrat de silicium.

4. Procédé de production d'un film BEDT-TTF déposé en phase vapeur, ce procédé comprend les étapes de :
chauffer BEDT-TTF à une température prédéterminée jusqu'à 260°C sous vide ; et
former un film BEDT-TTF sur un substrat maintenu à une température inférieure à la température à laquelle ledit BEDT-TTF est chauffé.

5. Procédé selon la revendication 4, comprenant en outre l'étape d'incorporer un accepteur d'électrons dans le film BEDT-TTF.

6. Procédé selon la revendication 4 ou 5, où on forme le film BEDT-TTF sur le substrat en chauffant le BEDT-TTF à une température pouvant atteindre 250°C et à une pression de 1,333 Pa (10⁻² torr) ou en dessous.

7. Procédé selon l'une quelconque des revendications 4 à 6, où on forme le film BEDT-TTF sur le substrat dans une enceinte de dépôt de vapeur tubulaire avec un gradient de température créé le long de la paroi du tube, et où la distance entre le substrat et la cellule d'alimentation de l'appareil de dépôt en phase vapeur est dans l'intervalle de 5 à 15 cm.

8. Procédé selon l'une quelconque des revendications 5 à 7, où l'accepteur d'électrons est incorporé dans le film BEDT-TTF par un procédé électrolytique.

9. Procédé selon l'une quelconque des revendications 5 à 8, où l'accepteur d'électrons est au moins un anion choisi parmi X₃⁻ et MX₂⁻ (où X est un atome d'halogène ou un pseudohalogénure ; et M est un atome de métal).

10. Procédé selon l'une quelconque des revendications 4 à 9, où le substrat est un substrat de silicium.
